# EUROPEAN PATENT APPLICATION

(11) **EP 1 476 004 A2**
(43) Date of publication of application: **10.11.2004**
(21) Application number: 04009609.1
(22) Date of filing: 22.04.2004
(51) Int. Cl.: H05K 3/10, H05K 3/18

(54) **Method for producing wired circuit board**

(30) Priority: 08.05.2003 JP 2003130807
(71) Applicant: NITTO DENKO CORPORATION, Ibaraki-shi, Osaka 567-8680 (JP)
(72) Inventor: Naito, Toshiki, Ibaraki-shi Osaka 567-8680 (JP); Yamazaki, Hiroshi, Ibaraki-shi Osaka 567-8680 (JP); Yamato, Takeshi, Ibaraki-shi Osaka 567-8680 (JP)
(74) Representative: Schwabe - Sandmair - Marx

(57) **Abstract**

A method for producing a wired circuit board that can provide improved productivity and economical efficiency, while preventing the forming failure of the wired circuit board due to which when a conductor layer is formed by plating, the plating material is caused to penetrate under the plating resist or the plating resist is caused to strip. In the method, after a thin conductor film 2 is formed on an insulating base layer 1, liquid solution of photosensitive resist is applied to the thin conductor film 2 and then dried, thereby forming the first plating resist layer 3 on the thin conductor film 2. Then, a film of photosensitive resist is adhesively bonded to the first plating resist layer 3, thereby forming the second plating resist layer 4. Thereafter, the first and the second plating resist layers 3, 4 are formed into a reversal pattern to a wired circuit pattern by a photographic process. Then, a conductor layer 5 is formed by electrolytic plating in the form of the wired circuit pattern on the exposed thin conductor film 2. Then, the first and second plating resist layers 3, 4 and the thin conductor film 2 at portions thereof where the first and second plating resist layers 3, 4 were removed are removed.

## Description

### BACKGROUND OF THE INVENTION

### Field of the Invention

The present invention relates to a method for producing a wired circuit board and, more particularly, to a method for producing a wired circuit board by a semi-additive process or an additive process.

### Description of the Prior Art

In general, the subtractive process is widely known as a process for forming a wired circuit pattern on a wired circuit board such as a flexible wired circuit board.

In the subtractive process, after a copper clad laminate comprising an insulating layer and a copper foil is prepared, an etching resist of a predetermined pattern is formed on a surface of the copper foil of the copper clad laminate by a photographic process. Then, the surface of the copper foil exposed from the etching resist is etched by etching solution (etchant), such as ferric chloride, to form the copper foil into a wired circuit pattern.

In recent years, improvement to fine pitch is being increasingly demanded for the wiring pattern of the wired circuit board and the like for mounting thereon a semiconductor device for liquid crystal device, along with which the semi-additive process and the additive process for forming the wired circuit pattern by plating are now drawing attention.

In the semi-additive process, after a thin conductor film is formed on an insulating layer by sputtering or by electroless plating, a photosensitive resist is laminated on the thin conductor film. Then, the photosensitive resist is patterned into a predetermined pattern by photographic process to form a plating resist. Sequentially, after the conductor layer is formed by electrolytic plating in the form of the wired circuit pattern on a surface of the thin conductor film exposed from the plating resist, the plating resist and the thin conductor film at portions thereof where the plating resist was formed are removed by etching.

In the additive process, after a photosensitive resist is laminated on an insulating layer, the photosensitive resist is patterned into a predetermined pattern by photographic process to form a plating, resist. Sequentially, after the conductor layer is formed by electroless plating in the form of the wired circuit pattern on a surface of the insulating layer exposed from the plating resist, the plating resist is removed by etching.

The photosensitive resist used in the semi-additive process or in the additive process is roughly classified into liquid photoresist and film photoresist.

The liquid photoresist is liquid solution of photosensitive resist, having the capabilities of easily forming a film by simply applying and drying it and smoothly tracing irregularities of the surface of the insulating layer or the surface of the thin conductor film, to provide high adhesion thereto. However, since the plating resist formed is required to have a larger thickness than the conductor layer plated, a cubic volume of liquid photoresist actually required to obtain the required thickness formed by solid content of liquid photoresist is several times as much as the cubic volume after dried. Thus, the liquid photoresist has the disadvantage of being inefficient in productivity and economical efficiency.

On the other hand, the film photoresist is a preformed film of the photosensitive resist, having the advantage of being efficient in productivity and economical efficiency from the standpoints mentioned above. However, the film photoresist is inferior to the liquid photoresist in the tracing of irregularities of the surface of the insulating layer or the surface of the thin conductor film and thus is inferior to the liquid photoresist in the adhesion thereto. For example, when the conductor layer is formed by plating, the insufficient adhesion of the plating resist to the insulating layer or the thin conductor film causes the plating material to penetrate under the plating resist or causes the plating resist to strip, thereby causing the forming failure of the wired circuit pattern.

For example Japanese Laid-open (Unexamined) Patent Publication No. Hei 5-275833 proposes the additive process in which a second photosensitive plating resist containing no dye is laminated on a first photosensitive plating resist containing a dye, to thereby produce the plating resist having double-layer structure. This double layer structure can make a bottom portion of the plating resist equal in width to a photic portion of the pattern mask in such a manner that the plating resist is prevented from the photo-polymerization caused by the light diffracted by a pattern mask until it becomes insoluble in developing solution, and, as a result, improvement of resolution is achieved.

However, the both plating resists described in Japanese Laid-open (Unexamined) Patent Publication No. Hei 5-275833 cited above, i.e., the first photosensitive plating resist containing the dye and the second photosensitive plating resist containing no dye, are the liquid photoresist, as described in Examples. Therefore, this proposed process using the liquid photoresist has the disadvantages of being inefficient in productivity and economical efficiency, as is the above mentioned case. Thus, this process cannot solve all the disadvantages noted above, either.

### SUMMARY OF THE INVENTION

It is the object of the invention to provide a method for producing a wired circuit board that can provide improved productivity and economical efficiency, while preventing the forming failure of the wired circuit board caused by insufficient adhesion of a plating resist due to which when a conductor layer is formed by plating, plating material is caused to penetrate under the plating resist or the plating resist is caused to strip.

The present invention provides a novel method for producing a wired circuit board comprising an insulating layer and a conductor layer formed in the form of a wired circuit pattern on the insulating layer, the method comprising: the step of applying liquid solution of photosensitive resist to a surface of the insulating layer, to form a first plating resist layer, the step of adhesively bonding a film of photosensitive resist to a surface of the first plating resist layer, to form a second plating resist layer, the step of exposing the first plating resist layer and the second plating resist layer to light and developing them, to form the first and second plating resist layers into a predetermined pattern, and the step of forming the conductor layer by plating in the form of a wired circuit pattern on the insulating layer at portions thereof where the first and second plating resists formed into the predetermined pattern were not formed.

According to this method, since the liquid solution of photosensitive resist is applied to the insulating layer, to form the first plating resist layer, the first plating resist layer can smoothly trace irregularities of the surface to which the liquid photoresist is applied. This can produce high adhesion of the first plating resist layer to the surface to which the liquid-photoresist is applied. As a result of this, when the conductor layer is formed by plating, the plating material can be well prevented from penetrating under the first plating resist layer or the first plating resist layer can be prevented from stripping, thus preventing the forming failure of the wired circuit pattern resulting therefrom.

Also, in this method, the film of photosensitive resist is adhesively bonded to the first plating resist layer, to laminate the second plating resist layer on the first plating resist layer, thereby forming the entirety of the plating resist layer. In other words, the entirety of the plating resist layer is formed by combination of the first plating resist layer of the liquid solution of photosensitive resist and the second plating resist layer of the film of photosensitive resist, rather than by the first plating resist layer alone. This can provide reduction in amount of liquid solution of the photosensitive resist applied to form the first plating resist layer. This can achieve improvement in productivity and economical efficiency. Thus, this method can produce a reliable wired circuit pattern with improved productivity and economical efficiency.

In the method of producing the wired circuit board of the present invention, it is preferable that the first plating resist layer is smaller in thickness than the second plating resist layer.

By rendering the thickness of the first plating resist layer smaller than the thickness of the second plating resist layer, further improvement in productivity and economical efficiency can be achieved.

In the method for producing the wired circuit board of the present invention, the step of forming the first plating resist layer may comprise the step of forming the thin conductor film on the insulating layer and then applying liquid solution of photosensitive resist to a surface of the thin conductor film, while also, the step of forming the conductor layer into the wired circuit pattern may comprise the step of forming the conductor layer by electrolytic plating in the form of a wired circuit pattern on the thin conductor film exposed from the first and second plating resist layers formed into the predetermined pattern, the step of removing the first and second plating resist layers formed into the predetermined pattern, and the step of removing the thin conductor film at portions thereof where the first and second plating resist layers were removed.

This can allow the use of the semi-additive process in the method for producing the wired circuit board of the present invention.

In the method for producing the wired circuit board of the present invention, the step of forming the first plating resist layer may comprise the step of applying liquid solution of photosensitive resist directly to a surface of the insulating layer, while also, the step of forming the conductor layer into the wired circuit pattern may comprise the step of forming the conductor layer by electroless plating in the form of a wired circuit pattern on the insulating layer exposed from the first and second plating resist layers formed into the predetermined pattern and the step of removing the first and second plating resist layers formed into the predetermined pattern.

This can allow the use of the additive process in the method for producing the wired circuit board of the present invention.

### BRIEF DESCRIPTION OF THE DRAWINGS

In the drawings:

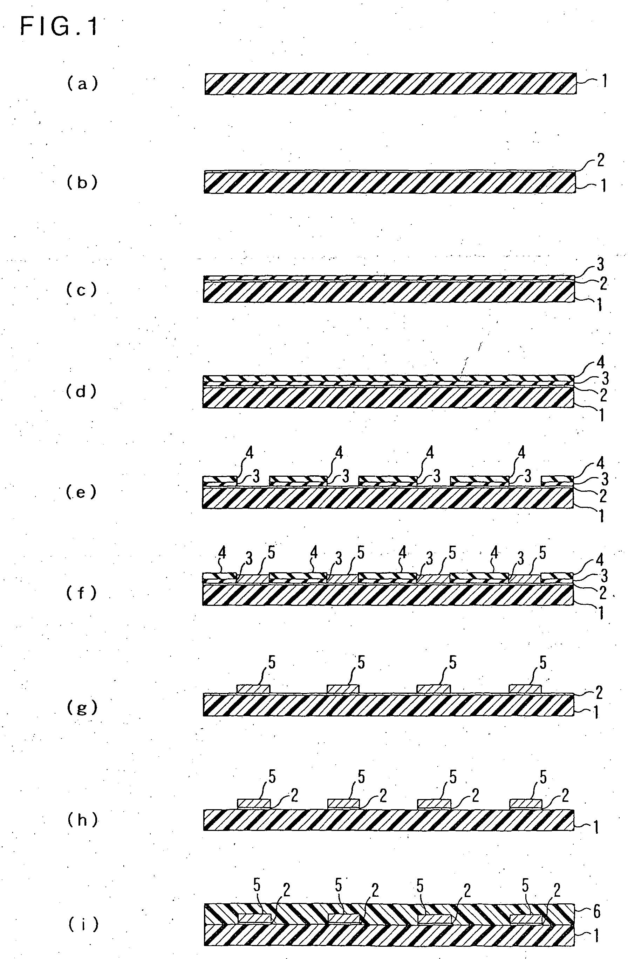

FIG. 1 shows the process drawing of a method for producing a flexible wired circuit board by a semi-additive process which is taken as an embodiment of a method of producing a wired circuit board of the present invention:
   (a) shows the step of preparing an insulating base layer;
   (b) shows the step of forming a thin conductor film on the insulating base layer;
   (c) shows the step of applying liquid solution of photosensitive resist to a surface of the thin conductor film and drying it, to form a first plating resist layer thereon;
   (d) shows the step of adhesively bonding a film of photosensitive resist to the first plating resist layer, to form a second plating resist layer thereon;
   (e) shows the step of forming the first plating resist layer and second plating layer into a reversal pattern to a wired circuit pattern;
   (f) shows the step of forming a conductor layer by electrolytic plating in the form of a wired circuit pattern on the thin conductor film exposed from the first plating resist and second plating resist;
   (g) shows the step of removing the first and second plating resists;
   (h) shows the step of removing the thin conductor film at portions thereof where the first and second plating resists were removed; and
   (i) shows the step of covering an insulating cover layer over the conductor layer, and

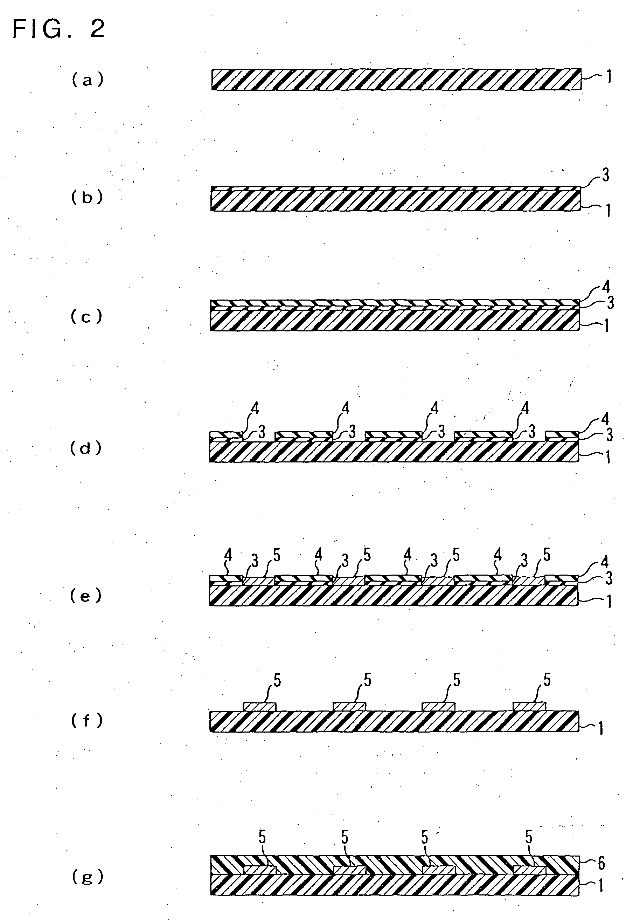

FIG. 2 shows the process drawing of a method for producing a flexible wired circuit board by an additive process which is taken as an embodiment of a method of producing a wired circuit board of the present invention:
   (a) shows the step of preparing an insulating base layer;
   (b) shows the step of applying liquid solution of photosensitive resist to a surface of the insulating base layer and drying it, to form a first plating resist layer thereon;
   (c) shows the step of adhesively bonding a film of photosensitive resist to the first plating resist layer, to form a second plating resist layer thereon;
   (d) shows the step of forming the first plating resist layer and second plating layer into a reversal pattern to a wired circuit pattern;
   (e) shows the step of forming a conductor layer by electroless plating in the form of a wired circuit pattern on the insulating base layer exposed from the first plating resist and second plating resist;
   (f) shows the step of removing the first and second plating resists; and
   (g) shows the step of covering an insulating cover layer over the conductor layer.

### DETAILED DESCRIPTION OF THE PREFERRED EMBODIMENTS

Referring to FIG. 1, there is shown the process drawing of a method for producing a flexible wired circuit board by a semi-additive process which is taken as an embodiment of a method of producing a wired circuit board of the present invention.

In this method, an insulating base layer 1 is prepared as an insulating layer, first, as shown in FIG. 1(a).

No particular limitation is imposed on the material used for the insulating base layer 1. The materials commonly used for the insulating base layer of a flexible wired circuit board may be used for the insulating base layer 1. For example, a resin film formed of insulative and flexible resin, such as polyimide resin, acrylic resin, polyether nitrile resin, polyether sulfonic resin, polyethylene terephthalate resin, polyethylene naphthalate resin, and polyvinyl chloride resin, can be used as the insulating base layer 1.

Of these resin films, a resin film of polyimide resin is preferably used in terms of chemical resistance, heat resistance and dimensional stability. The resin film may be formed by patterning by exposing a photosensitive resin to light and then developing it. The insulating base layer 1 is set to have a thickness in the range of e.g. 3-50 µ m, or preferably 5-30 µ m.

Then, a thin conductor film 2 is formed on the insulating base layer 1, as shown in FIG. 1(b).

The thin conductor film 2 can be formed by a known process used in the semi-additive process, with no particular limitation thereon. For example, deposition methods, such as vacuum deposition, ion plating, and sputtering, and plating, such as electroless plating, can be used to form the thin conductor film 2. Of these methods, the sputtering is preferably used.

No particular limitation is imposed on the conductor to form the thin conductor film 2. For example, Ni, Cr, Cu, Ni/Cr alloy, Cu/Ni alloy, Ti, and alloys thereof can be used for the conductor. The thin conductor film 2 has a thickness in the range of e.g. 10-500nm, or preferably 50-300nm. Also, the thin conductor film 2 may be formed in the form of a multilayer film comprising two or more layers.

Then, liquid solution of photosensitive resist is applied to the thin conductor film 2 and then is dried, to form a first plating resist layer 3 on the thin conductor layer 2, as shown in FIG. 1(c).

No particular limitation is imposed on the liquid solution of photosensitive resist used for forming the first plating resist layer 3. Any known liquid photoresist may be used. As the liquid photoresist is usually prepared by dissolving photosensitive resin in an organic solvent, it can be properly selected from the known liquid photoresists. For example, the liquid photoresist with a solid content of 20-80 weight%, or preferably 35-65 weight%, is preferably used for forming the first plating resist layer 3.

The liquid solution of photosensitive resist can be applied to a surface of the thin conductor film 2 by a known method using a resist coater and the like. The liquid solution of photosensitive resist applied but before dried has a thickness of e.g. 2-20 µ m, or preferably 4-14 µ m, depending on a solid content of the liquid photoresist used.

Then, the liquid solution of photosensitive resist applied is dried in a drying furnace and the like at a drying temperature of the organic solvent or more, e.g. 50-150°C, or preferably 70-120°C. The first plating resist layer 3 is formed in this manner.

It is preferable that the first plating resist layer 3 thus formed is smaller in thickness than the second plating resist layer 4 for the purpose of improvement in productivity and economical efficiency. It is set to be in the range of e.g. 1-10 µ m, or preferably 2-7 µ m. When the thickness of the first plating resist layer 3 is smaller than this, it may fail to provide the efficient smoothening of the surface to which the liquid photoresist is applied, to cause a possible reduction in adhesion of the film photoresist to form a second plating resist layer 4. On the other hand, when the thickness of the first plating resist layer 3 is larger than this, it may provide a possible reduction in productivity and economical efficiency.

Then, a film of photosensitive resist is adhesively bonded to the first plating resist layer 3 to form the second plating resist layer 4, as shown in FIG. 1(d).

No particular limitation is imposed on the film of photosensitive resist used for forming the second plating resist layer 4. Any known film photoresist may be used. As the film photoresist is usually prepared in the form of a dry film photoresist comprising photosensitive resin, it can be properly selected from the known film photoresists.

The film of photosensitive resist can be laminated on the first plating resist layer 3 by a known method using a known laminator with a heat roller and the like. The second plating resist layer 4 is formed in this manner.

The second plating resist layer 4 thus formed has a thickness of e.g. 5-20 µ m, or preferably 7-15 µ m. When the thickness of the second plating resist layer 4 is smaller than this, it may fail to obtain an aspect ratio required for forming a conductor layer 5. On the other hand, when the thickness of the second plating resist layer 4 is larger than this, it may provide a possible reduction in productivity and economical efficiency.

It is necessary that a total thickness of the first and second plating resist layers 3, 4 thus formed is larger than the thickness of the conductor layer 5. For example, when the conductor layer 5 has a thickness of 3-25 µ m, the first and second plating resist layers 3, 4 preferably have a total thickness of 6-30 µ m.

A thickness ratio of the second plating resist layer 4 to the thickness of the first plating resist layer 3 (2nd plating resist layer 4/lst plating resist layer 3) is set to be in the range of e.g. 1-20, or preferably 3-8.

It is to be noted that either of a positive tone resist and a negative tone resist may be used for the first plating resist layer 3 and the second plating resist layer 4, as long as the tone resist for the first plating resist layer 3 and the second plating resist layer 4 are the same tone.

Then, the first plating resist layer 3 and the second plating resist layer 4 are formed into a reversal pattern to a wired circuit pattern of the conductor layer 5 to be formed next, as shown in FIG. 1(e).

No particular limitation on the method for forming the first plating resist layer 3 and the second plating resist layer 4 into the reversal pattern to the wired circuit pattern. The first and second plating resist layers 3, 4 may be formed into the reversal pattern to the wired circuit pattern by any known photographic process in which the plating resist layers are exposed to light and then developed in accordance with the positive tone resist or the negative tone resist.

Then, the conductor layer 5 is formed by electrolytic plating in the form of the wired circuit pattern on the thin conductor film 2 at portions thereof where the first and second plating resist layers 3, 4 are not formed, or on the thin conductor film 2 exposed from the first and second plating resist layers 3, 4 formed in the form of the reversal pattern, as shown in FIG. 1(f).

No particular limitation is imposed on the metal used for forming the conductor layer 5. For example, copper, chromium, nickel, aluminum, stainless steel, copper-beryllium, phosphor bronze, iron-nickel and alloys thereof may be used for the conductor layer 5. Copper is preferably used. The conductor layer 5 is formed to have a thickness in the range of e.g. 3-25 µ m, or preferably 5-15 µ m.

Then, the first and second plating resist layers 3, 4 formed in the form of the reversal pattern are removed, as shown in FIG. 1(g).

No particular limitation is imposed on the method for removing the first and second plating resist layers 3, 4. Any method usually used in the semi-additive process may be used. For example, a stripping method using a stripping agent, such as an alkali stripping agent, or an etching method, such as a chemical etching (wet etching), may be used for removing the first and second plating resist layers 3, 4.

Thereafter, the thin conductor film 2 at portions thereof where the first and second plating resist layers 3, 4 were removed is removed, as shown in FIG. 1(h), thereby forming a flexible wired circuit.

No particular limitation is imposed on the method for removing the thin conductor film 2. Any method usually used in the semi-additive process may be used. For example, a known etching method, such as a chemical etching (wet etching) using the etching solution such as acid etching solution, may be used for removing the thin conductor film 2.

Additionally, an insulating cover layer 6 may be covered over the conductor layer 5, as shown in FIG. 1(i).

The same resin as that of the insulating base layer 1 may be used for the insulating cover layer 6. Polyimide resin is preferably used for the insulating cover layer 6. No particular limitation is imposed on the method for forming the insulating cover layer 6. For example, solution resin or molten resin may be applied to or printed on the insulating base layer 1 including the conductor layer 5 and then dried and cured. Also, the resin may be adhesively bonded to the insulating base layer 1 including the conductor layer 5 through a known adhesive sheet. Further, the photosensitive resin may be exposed to light and then developed, to form a pattern. The insulating cover layer 6 is formed to have a thickness in the range of e.g. 3-30 µ m, or preferably 5-20 µ m.

When this insulating cover layer 6 is formed, openings are formed at proper positions of the flexible wired circuit board, such as ends of the flexible wired circuit board, so that terminal portions of the conductor layer 5 formed in a predetermined wired circuit pattern are exposed from the insulating cover layer 6, though not shown. No particular limitation is imposed on the method for forming the opening. For example, a known method, such as drilling, punching, laser machining, or etching, may be used for forming the openings. When the photosensitive resin is used to form the pattern, the openings and the insulating cover layer 6 can be formed simultaneously.

When the flexible wired circuit board is produced in this semi-additive process, the following results can be provided. That is to say, in this method, after the thin conductor film 2 is formed on the insulating base layer 1, the liquid solution of photosensitive resist is applied to the thin conductor film 2, thereby forming the first plating resist layer 3 on the thin conductor film 2. This enables the first plating resist layer 3 to smoothly trace irregularities of the surface of the thin conductor film 2. This can produce high adhesion of the first plating resist layer 3 to the surface of the thin conductor film 2. As a result of this, when the conductor layer 5 is formed by plating, the plating material can be well prevented from penetrating under the first plating resist layer 3 or the first plating resist layer 3 can be prevented from stripping, thus preventing the forming failure of the wired circuit pattern resulting therefrom.

Also, in this method, the film of photosensitive resist is adhesively bonded to the first plating resist layer 3 to laminate the second plating resist layer 4 on the first plating resist layer 3, thereby forming the entirety of the plating resist layer. In other words, the entirety of the plating resist layer is formed by combination of the first plating resist layer 3 of the liquid solution of photosensitive resist and the second plating resist layer 4 of the film of photosensitive resist, rather than by the first plating resist layer 3 of the liquid solution of photosensitive resist alone. This can provide reduction in amount of liquid solution of the photosensitive resist applied to form the first plating resist layer 3. This can provide improvement in working efficiency in the application process and drying process, thus achieving improvement in productivity and economical efficiency. Thus, this method can produce a reliable wired circuit pattern with improved productivity and economical efficiency.

The method of producing the wired circuit board of the present invention is applicable to the additive process as well as to the semi-additive process.

Referring now to FIG. 2, the method for producing the flexible wired circuit board by the additive process which is taken as an embodiment of the method of producing the wired circuit board of the present invention will be described.

In this method, the insulating base layer 1 is prepared as the insulating layer, first, in the same manner as in the above mentioned method, as shown in FIG. 2(a).

Then, the liquid solution of photosensitive resist is applied to the insulating base layer 1 and then dried in the same manner as in the above mentioned method, to form the first plating resist layer 3 on the insulating base layer 1, as shown in FIG. 2(b).

Then, a film of photosensitive resist is adhesively bonded to the first plating resist layer 3 in the same manner as in the above mentioned method, to form the second plating resist layer 4, as shown in FIG. 2(c).

Then, the first plating resist layer 3 and the second plating resist layer 4 are formed into a reversal pattern to a wired circuit pattern of the conductor layer 5 to be formed next in the same manner as in the above mentioned method, as shown in FIG. 2(d).

Then, the conductor layer 5 is formed by electroless plating in the form of the wired circuit pattern on the insulating base layer 1 at portions thereof where the first and second plating resist layers 3, 4 are not formed, or on the insulating base layer 1 exposed from the first and second plating resist layers 3, 4 formed in the form of the reversal pattern, as shown in FIG. 2(e). The metal used to form the conductor layer 5 and the thickness of the conductor layer 5 are the same as those mentioned in the above method.

Then, the first and second plating resist layers 3, 4 formed in the form of the reversal pattern are removed in the same manner as in the above mentioned method, as shown in FIG. 2(f), thereby forming a flexible wired circuit board.

Additionally, the insulating cover layer 6 may be covered over the conductor layer 5 in the same manner as in the above mentioned method, as shown in FIG. 2(g).

When the flexible wired circuit board is produced in this additive process, the substantially same results as in the case mentioned above can be provided. Specifically, in this method also, the liquid solution of photosensitive resist is applied to the insulating base layer 1, thereby forming the first plating resist layer 3 on the insulating base layer 1. This enables the first plating resist layer 3 to smoothly trace the irregularities of the surface of the insulating base layer 1. This can produce high adhesion of the first plating resist layer 3 to the surface of the insulating base layer 1. As a result, when the conductor layer 5 is formed by plating, the plating material can be well prevented from penetrating under the first plating resist layer 3 or the first plating resist layer 3 can be prevented from stripping, thus preventing the forming failure of the wired circuit pattern resulting therefrom.

Also, in this method, the film of photosensitive resist is adhesively bonded to the first plating resist layer 3 to laminate the second plating resist layer 4 on the first plating resist layer 3, thereby forming the entirety of the plating resist layer. In other words, the entirety of the plating resist layer is formed by combination of the first plating resist layer 3 of the liquid solution of photosensitive resist and the second plating resist layer 4 of the film of photosensitive resist, rather than by the first plating resist layer 3 of the liquid solution of photosensitive resist alone. This can provide reduction in amount of liquid solution of the photosensitive resist applied to form the first plating resist layer 3. This can provide improvement in working efficiency in the application process and drying process, thus achieving improvement in productivity and economical efficiency. Thus; this method can also produce a reliable wired circuit pattern with improved productivity and economical efficiency.

### Examples

In the following, the present invention will be described in further detail with reference to Example and Comparative Examples.

### Example 1

A film of polyimide resin (250mm wide and 25 µ m thick/ UPILEX-S (product name) available from Ube Industries, Ltd.) was prepared as the insulating base layer (Cf. FIG. 1(a)). Then, a thin chromium film having thickness of 150Å and a thin copper film having thickness of 1,000Å were sequentially formed in the form of a thin conductor film on one surface of the insulating base layer (Cf. FIG. 1(b)).

Then, negative tone liquid photoresist (OPTO-ER N-400 (product name) available from Nippon Paint Co., Ltd.) was applied to the thin conductor film by a resist coater and then dried by passing through a drying furnace of 100°C directly, thereby forming the first plating resist layer having thickness of 3µm (Cf. FIG. 1(c)).

Sequentially, a negative tone film photoresist (SPG152 (product name) available from Asahi Kasei Chemicals) was laminated on the first plating resist layer via a vacuum laminator by passing through a heat roller heated to 115°C, thereby forming the second plating resist layer having thickness of 15µm (Cf. FIG. 1(d)).

The total thickness of the first and second plating resist layers thus formed was 18µm.

Then, the first and second plating resist layers were exposed to light at 200mJ/cm² through a photomask having a predetermined pattern and then developed in aqueous solution of 1 weight% sodium carbonate, thereby forming the first and second plating resist layers into a predetermined pattern (Cf. FIG. 1(e)).

Then, a conductor layer of copper was formed in the form of a wired circuit pattern having thickness of 15µm on the thin conductor film exposed from the first and second plating resist layers by electrolytic copper plating (Cf. FIG. 1(f)).

Thereafter, the first and second plating resist layers were dissolved by etching to be removed (Cf. FIG. 1(g)) and then the thin conductor film at portions thereof where the first and second plating resist layers were removed was dissolved by etching to be removed, thereby producing a flexible wired circuit board (FIG. 1(h)).

In the flexible wired circuit board of Example 1, although the conductor layer was formed by plating in the form of a fine wired circuit pattern having a minimum wiring width of 15µm and a minimum gap of 15µm, it was confirmed in the production process that the plating material was prevented from penetrating under the first plating resist layer or the first plating resist layer was prevented from stripping.

### Example 2

A film of polyimide resin (250mm wide and 25µm thick/ UPILEX-S (product name) available from Ube Industries, Ltd.) was prepared as the insulating base layer (Cf. FIG. 2(a)). Then, negative tone liquid photoresist (OPTO-ER N-400 (product name) available from Nippon Paint Co., Ltd.) was applied to one surface of the insulating base layer by the resist coater and then dried by passing through the drying furnace of 100°C directly, thereby forming the first plating resist layer having thickness of 3µm (Cf. FIG. 2(b)).

Sequentially, a negative tone film photoresist (SPG152 (product name) available from Asahi Kasei Chemicals) was laminated on the first plating resist layer via the vacuum laminator by passing the film photoresist through the heat roller heated to 115°C, thereby forming the second plating resist layer having thickness of 15µm (Cf. FIG. 2(c)). The total thickness of the first and second plating resist layers thus formed was 18µm.

Then, the first and second plating resist layers were exposed to light at 200mJ/cm² through the photomask having a predetermined pattern and then developed in aqueous solution of 1 weight% sodium carbonate, thereby forming the first and second plating resist layers into a predetermined pattern (Cf. FIG. 2 (d)).

Then, a conductor layer of copper was formed in the form of a wired circuit pattern having thickness of 15µm on the insulating base layer exposed from the first and second plating resist layers by electroless copper plating (Cf. FIG. 2(e)).

Thereafter, the first and second plating resist layers were dissolved by etching to be removed (Cf. FIG. 1(g)), thereby producing a flexible wired circuit board (FIG. 2(f)).

In the flexible wired circuit board of Example 2, although the conductor layer was formed by plating in the form of the fine wired circuit pattern having a minimum wiring width of 15µm and a minimum gap of 15µm, it was confirmed in the production process that the plating material was prevented from penetrating under the first plating resist layer or the first plating resist layer was prevented from stripping.

### Comparative Example 1

Except that the first plating resist layer was not formed on the thin conductor film by using the negative tone liquid photoresist, but the negative tone film photoresist (SPG152 (product name) available from Asahi Kasei Chemicals) was laminated on the thin conductor film via the vacuum laminator by passing the film photoresist through the heat roller heated to 115°C, thereby forming the second plating resist layer having thickness of 20pm alone, the same processes as those in Example 1 were taken to produce a flexible wired circuit board.

In the flexible wired circuit board of Comparative Example 1, when the conductor layer was formed by plating in the form of the fine wired circuit pattern having a minimum wiring width of 15µm and a minimum gap of 15µm, it was found that the plating material penetrated under the second plating resist layer to cause the forming failure of the wired circuit pattern.

### Comparative Example 2

Except that the first plating resist layer was not formed on the insulating base layer by using the negative tone liquid photoresist, but the negative tone film photoresist (SPG152 (product name) available from Asahi Kasei Chemicals) was laminated on the insulating base layer via the vacuum laminator by passing through the heat roller heated to 115°C, thereby forming the second plating resist layer having thickness of 20µm alone, the same processes as those in Example 2 were taken to produce a flexible wired circuit board.

In the flexible wired circuit board of Comparative Example 2, when the conductor layer was formed by plating in the form of the fine wired circuit pattern having a minimum wiring width of 15µm and a minimum gap of 15µm, it was found that the plating material penetrated under the second plating resist layer to cause the forming failure of the wired circuit pattern.

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A method for producing a wired circuit board comprising an insulating layer and a conductor layer formed in the form of a wired circuit pattern on the insulating layer, the method comprising:
the step of applying liquid solution of photosensitive resist to a surface of the insulating layer, to form a first plating resist layer,
the step of adhesively bonding a film of photosensitive resist to a surface of the first plating resist layer, to form a second plating resist layer,
the step of exposing the first plating resist layer and the second plating resist layer to light and developing them, to form the first and second plating resist layers into a predetermined pattern, and
the step of forming the conductor layer by plating in the form of a wired circuit pattern on the insulating layer at portions thereof where the first and second plating resists formed into the predetermined pattern were not formed.

2. The method for producing the wired circuit board according to Claim 1, wherein the first plating resist layer is smaller in thickness than the second plating resist layer.

3. The method for producing the wired circuit board according to Claim 1, wherein the step of forming the first plating resist layer comprises the step of forming the thin conductor film on the insulating layer and then applying liquid solution of photosensitive resist to a surface of the thin conductor film, and wherein the step of forming the conductor layer into the wired circuit pattern comprises the step of forming the conductor layer by electrolytic plating in the form of a wired circuit pattern on the thin conductor film exposed from the first and second plating resist layers formed into the predetermined pattern, the step of removing the first and second plating resist layers formed into the predetermined pattern, and the step of removing the thin conductor film at portions thereof where the first and second plating resist layers were removed.

4. The method for producing the wired circuit board according to Claim 1, wherein the step of forming the first plating resist layer comprises the step of applying liquid solution of photosensitive resist directly to a surface of the insulating layer, and wherein the step of forming the conductor layer in the form of the wired circuit pattern comprises the step of forming the conductor layer by electroless plating in the form of a wired circuit pattern on the insulating layer exposed from the first and second plating resist layers formed into the predetermined pattern and the step of removing the first and second plating resist layers formed into the predetermined pattern.
